# EUROPEAN PATENT APPLICATION

(11) **EP 4 793 953 A1**
(43) Date of publication of application: **19.08.2026**
(21) Application number: 25842103.1
(22) Date of filing: 20.05.2025
(51) Int. Cl.: G11C 29/44, G11C 29/00

(54) **MEMORY OPERATION METHOD, MEMORY, ELECTRONIC DEVICE, AND STORAGE MEDIUM**

(30) Priority: 25.12.2024 CN 202411930802
(71) Applicant: Hygon Information Technology Co., Ltd., Tianjin 300392 (CN)
(72) Inventor: XIE, Fei, Tianjin 300392 (CN); ZHOU, Peng, Tianjin 300392 (CN)
(74) Representative: Maiwald GmbH
(86) International application number: PCT/CN2025/096058
(87) International publication number: WO 2026/137684

(57) **Abstract**

Embodiments of the present disclosure provide a memory operation method, a memory, an electronic device and a storage medium. The memory operation method includes: determining an error location of an error in a memory array in response to detecting the error in the memory array of a memory in a working state of the memory; controlling the memory to start a post package repair process after the memory enters an idle state, and replacing, according to the error location, a target storage unit at the error location with a replacement storage unit used for the post package repair process in the memory array; and switching the memory back to the working state after the post package repair process, and using the replacement storage unit to replace the target storage unit for operation. The memory operation method can improve the reliability of the memory.

## Description

### CROSS-REFERENCE TO RELATED APPLICATION

The present application claims priority to Chinese Patent Application No. 202411930802.2, filed on December 25, 2024, the disclosure of which is incorporated herein by reference in its entirety as a part of the present application.

### TECHNICAL FIELD

Embodiments of the present disclosure relate to a memory operation method, a memory, an electronic device, and a storage medium.

### BACKGROUND

As the demand for memory access by modern computer systems continues to grow, the storage dies in the memory are subjected to high load operation in harsh environment for a long period of time, and are highly susceptible to failure due to aging and the like. The failure of the storage will cause the stability of the computer system to decline. If the failure of the storage cannot be repaired in time, it will even cause system downtime and other abnormalities.

### SUMMARY

At least one embodiment of the present disclosure provides a memory operation method including: determining an error location of an error in a memory array in response to detecting the error in the memory array of a memory in a working state of the memory; controlling the memory to start a post package repair process after the memory enters an idle state, and replacing, according to the error location, a target storage unit at the error location with a replacement storage unit used for the post package repair process in the memory array; and switching the memory back to the working state after the post package repair process, and using the replacement storage unit to replace the target storage unit for operation.

For example, in the memory operation method provided by at least some embodiments of the present disclosure, the controlling the memory to start a post package repair process after the memory enters an idle state includes switching the memory array from a working mode to a repair mode after the memory enters the idle state, so that the memory starts a post package repair process.

For example, the memory operation method provided in at least some embodiments of the present disclosure further includes: stop receiving a new access request to the memory and clearing existing access requests in the memory to enable the memory to enter the idle state.

For example, in the memory operation method provided by at least some embodiments of the present disclosure, before the memory enters an idle state, the memory operation method further includes releasing space of a data buffer occupied by the existing access requests.

For example, in the memory operation method provided by at least some embodiments of the present disclosure, after the memory enters an idle state, the memory operation method further includes: clearing a refresh command to be sent in the memory, so that the memory array enters a first self-refresh state; and switching control of the memory array from the working mode to the repair mode in the first self-refresh state.

For example, in the memory operation method provided by at least some embodiments of the present disclosure, the post package repair process includes backing up first data corresponding to the error location in response to the first self-refresh state being end, and restoring the first data to the replacement storage unit after the target storage unit is replaced with the replacement storage unit.

For example, in the memory operation method provided by at least some embodiments of the present disclosure, the backing up first data corresponding to the error location includes performing the backing up after processing the first data by an error correction algorithm.

For example, in the memory operation method provided by at least some embodiments of the present disclosure, the backing up first data corresponding to the error location further includes backing up the first data corresponding to the error location to a redundant space of the space of the data buffer.

For example, in the memory operation method provided by at least some embodiments of the present disclosure, the restoring the first data to the replacement storage unit includes: recombining the first data corresponding to the error location and second data written in parallel with the first data, and performing a write operation on the recombined data to restore the first data to the replacement storage unit.

For example, in the memory operation method provided by at least some embodiments of the present disclosure, the memory array is configured to support data masking; and the restoring the first data to the replacement storage unit includes: restoring the first data to the replacement storage unit by operating a corresponding data mask to mask out the operation of the second data to be written in parallel with the first data corresponding to the error location.

For example, the memory operation method provided by at least some embodiments of the present disclosure further includes sending a compensated refresh command in response to completion of the post package repair process.

For example, the memory operation method provided by at least some embodiments of the present disclosure further includes switching control of the memory array from the repair mode to the working mode in a second self-refresh state in response to completion of the repair mode.

For example, in the memory operation method provided by at least some embodiments of the present disclosure, before initiating the post package repair process, the memory operation method further includes reading a repair state register corresponding to the error location to determine whether repair resources are available.

For example, the memory operation method provided by at least some embodiments of the present disclosure further includes: triggering a hard repair on the memory array in response to a reset operation or an initialization operation on the memory, to fix, in the memory array of the memory, a repair result of replacing the target storage unit at the error location with the replacement storage unit for the post package repair process in the memory array.

At least one embodiment of the present disclosure further provides a memory including a memory array, an operation control module, a storage controller, and a repair module; where the storage controller is configured to perform reading and writing operations on the memory array in a working state; the repair module is configured to perform a repair operation on the memory array; the operation control module is configured to determine an error location of the error in the memory array in response to detecting an error in the memory array of the memory in the working state of the memory; control, after the memory enters an idle state, the memory to activate the repair module after the memory enters an idle state so as to perform a post package repair process, where the repair module is further configured to replace, according to the error location, a target storage unit at the error location with a replacement storage unit used for the post package repair process in the memory array; and switch the memory back to the working state after the post package repair process, thereby the storage controller using the replacement storage unit to replace the target storage unit for operation.

In the memory further provided in at least one embodiment of the present disclosure, the operation control module includes a selector, where an input terminal of the selector is connected to the storage controller and the repair control module, and an output terminal of the selector is connected to the memory array; and a permission switching module configured to provide a control signal to the selector to enable the selector to switch control of the memory array from the working mode to the repair mode or from the repair mode back to the working mode.

At least one embodiment of the present disclosure further provides a memory, which further includes a data buffer configured to provide a buffer space required for the memory array in the working mode or the repair mode.

At least one embodiment of the present disclosure further provides a memory, which further includes a repair state register configured to record whether repair resources are available at the error location.

At least some embodiments of the present disclosure further provide an electronic device including a memory provided by any one of the embodiments of the present disclosure.

At least some embodiments of the present disclosure further provide a non-transitory storage medium for non-transitorily storing computer-executable instructions, where the computer-executable instructions, when executed by at least one processor, implement the memory operation method provided by any of the embodiments of the present disclosure.

### BRIEF DESCRIPTION OF DRAWINGS

In order to explain the technical scheme of the embodiments of the present disclosure more clearly, the attached drawings of the embodiments will be briefly introduced below. Obviously, the attached drawings in the following description only relate to some embodiments of the present disclosure, and are not limited to the present disclosure.
Fig. 1 illustrates a flow diagram of a memory operation method provided by at least one embodiment of the present disclosure;
Fig. 2 illustrates a schematic diagram of data backup provided by at least one embodiment of the present disclosure;
Fig. 3 illustrates a schematic diagram of a data restoration provided by at least one embodiment of the present disclosure;
Fig. 4 illustrates an exemplary flow diagram of a memory operation method provided by at least one embodiment of the present disclosure;
Fig. 5 illustrates a block schematic diagram of a memory provided by at least one embodiment of the present disclosure;
Fig. 6 illustrates a block diagram of an electronic device provided by at least one embodiment of the present disclosure; and
Fig. 7 illustrates a schematic diagram of a non-transitory storage medium provided by at least one embodiment of the present disclosure.

### DETAILED DESCRIPTION

In order to make the purpose, technical scheme and advantages of the embodiment of the disclosure clearer, the technical scheme of the embodiment of the disclosure will be described clearly and completely with the attached drawings. Obviously, the described embodiment is a part of the embodiment of the present disclosure, not the whole embodiment. Based on the described embodiments of the present disclosure, all other embodiments obtained by ordinary people in the field without creative labor belong to the scope of protection of the present disclosure.

Unless otherwise defined, technical terms or scientific terms used in this disclosure shall have their ordinary meanings as understood by people with ordinary skills in the field to which this disclosure belongs. The terms "first", "second" and the like used in this disclosure do not indicate any order, quantity or importance, but are only used to distinguish different components. Similarly, similar words such as "a", "an" or "the" do not indicate a quantity limit, but indicate the existence of at least one. Similar words such as "including" or "containing" mean that the elements or objects appearing before the word cover the elements or objects listed after the word and their equivalents, without excluding other elements or objects. Similar words such as "connected" or "connected" are not limited to physical or mechanical connection, but can include electrical connection, whether direct or indirect. "Up", "Down", "Left" and "Right" are only used to indicate the relative positional relationship. When the absolute position of the described object changes, the relative positional relationship may also change accordingly.

The present disclosure is illustrated below by means of several specific embodiments. In order to keep the following description of the embodiments of the present disclosure clear and concise, a detailed description of known functions and known components may be omitted in the present disclosure. When any component of an embodiment of the present disclosure appears in more than one drawing, the component is identified in each drawing by the same or similar reference numeral.

The terms used in the present disclosure are those generally used in the art, which are currently widely used in view of functions related to the present disclosure, but the terms may be changed according to the intention of a person of ordinary skill in the art, precedents, or new techniques in the art. In addition, specific terms may be selected by the applicant, and in this case, a detailed meaning thereof will be described in the detailed description of the present disclosure. Therefore, the terms used in the specification should not be construed as simple names, but based on the meanings of the terms and the general description of the present disclosure.

Flowcharts are used in the present disclosure to illustrate operations performed by a system according to embodiments of the present disclosure. It should be understood that the preceding or following operations need not be performed in the exact order in which they are performed. On the contrary, the various steps may be processed in reverse order or simultaneously, as desired. At the same time, other operations may be added to or removed from the processes.

A storage, e.g., a memory, in the computer may be a Random-Access Memory memory (RAM), such as a dynamic random access memory (DRAM), or the like. The RAS property of memory refers to three key attributes, reliability, availability and serviceability, which together ensure the stability and data integrity of the computer system.

For example, the storage may be a memory employing a fourth generation dynamic random access memory technology (Double Data Rate Fourth, DDR4) or a fifth generation dynamic random access memory technology (Double Data Rate Fifth, DDR5).

Checking for bad spots (i.e., faulty or unreliable storage units) in the memory is an important step in ensuring system stability and data integrity. Different types of memories (e.g., DRAM, SRAM, NAND flash, etc.) may have different detection methods, including hardware diagnostic tools (e.g., BIST, built-In Self-Test) or software diagnostic tools (e.g., memory test software), etc. After bad spots being checked, repairs to the memory can be considered according to actual situation.

In the DDR4 memory technology, the function of Post Package Repair (PPR) is introduced, which significantly improves the reliability and durability of memory. The PPR function allows a redundant space to be introduced into the memory array, and supports the replacement of fixed errors in the memory array by the PPR process, so as to effectively repair errors in the memory array. For example, a single-bit error, a multi-bit error, a full-line error, etc., are repaired. DDR4 is only limited to repair fixed error types that belong to the same row range in the memory array, but with the advancement of technology, DDR5 further strengthens the PPR function on the basis of DDR4. The DDR5 memory technology implements two major types of repairs on the PPR functions: hard Post Package Repair (hPPR) and soft Post Package Repair (sPPR).

The hPPR allows at least one row address to be corrected for each bank in a memory array, and the repair is permanent. Once programmed, the electronic fuse cannot be switched back to an unfused state.

For example, when memory detects errors in the memory array is detected, it is first necessary to determine whether the errors are all confined to the same row in the memory array. If the errors are indeed located in the same row, a system interrupt will be sent, causing the system to enter a reset state. After the system exits the reset state, the initialization and training steps of memory particles(particles) in the memory array need to be completed, and the hPPR repair process begins.

For example, according to DDR standard protocol, a command is sent to enable the memory particles to enter the hPPR repair process. The row address required to be repaired is then passed to the memory particle, which then replaces the wrong row address with a row address in a redundant space. After the memory particle completes the hPPR repair process, the command is sent to exit and continue the rest of the initialization steps. When the system initialization process is finished, the memory re-enters the working state. After the fixed error row has been successfully replaced, the memory can normally perform reading and writing operations.

The sPPR provides a fast but temporary method of repairing a row address on a single bank. A power-down or a reset operation after the sPPR results in a loss of repair results, as compared to hPPR.

In the case where it is necessary to maintain a stable working state of a server or a computer system for a long time, if it is found that the memory has a partial failure or an error in a working state of a memory of the server or the computer system, both the hPPR and sPPR have some problems.

For example, if the hPPR is initiated, the work server or the computer system is required to perform a reset operation, which takes a long time, so that the working state of the server or the computer system must be interrupted. In a case where the working state must be maintained, errors in the memory therein cannot be processed in time, thereby continuously accumulating, or even directing the accumulation of errors to the downtime of the system.

For example, if the sPPR is initiated to temporarily repair memory in the working state, the repair is limited to the size of the redundant space in the memory array for the sPPR, and all repair results are lost upon power down occurs or a reset operation is performed.

At least one embodiment of the present disclosure provides a memory operation method including: determining an error location of an error in a memory array in response to detecting the error in the memory array of a memory in a working state of the memory; controlling the memory to start a post package repair process after the memory enters an idle state, and replacing, according to the error location, a target storage unit at the error location with a replacement storage unit used for the post package repair process in the memory array; and switching the memory back to the working state after the post package repair process, and using the replacement storage unit to replace the target storage unit for operation.

In the memory operation method of the above-mentioned embodiments of the present disclosure, since in response to detecting an error in a memory array of a memory in a working state of the memory, after the memory enters an idle state, a control starts a post package repair process. After the repair is completed, the memory is switched back to the working state, so that error repair of the memory can be performed by dynamically triggering the post package repair process in time while the memory is in the working state. On the one hand, the operation stability of the memory in the working state is improved, and the accumulation of errors caused by the long-term operation of the server or computer system is avoided. On the other hand, in the memory operation method, we can consider the reasonable utilization of the existing memory logic as much as possible, and avoid the use of complex logic devices, so as to obtain a higher benefit at a lower hardware cost.

Various embodiments of the present disclosure will now be described with reference to specific examples.

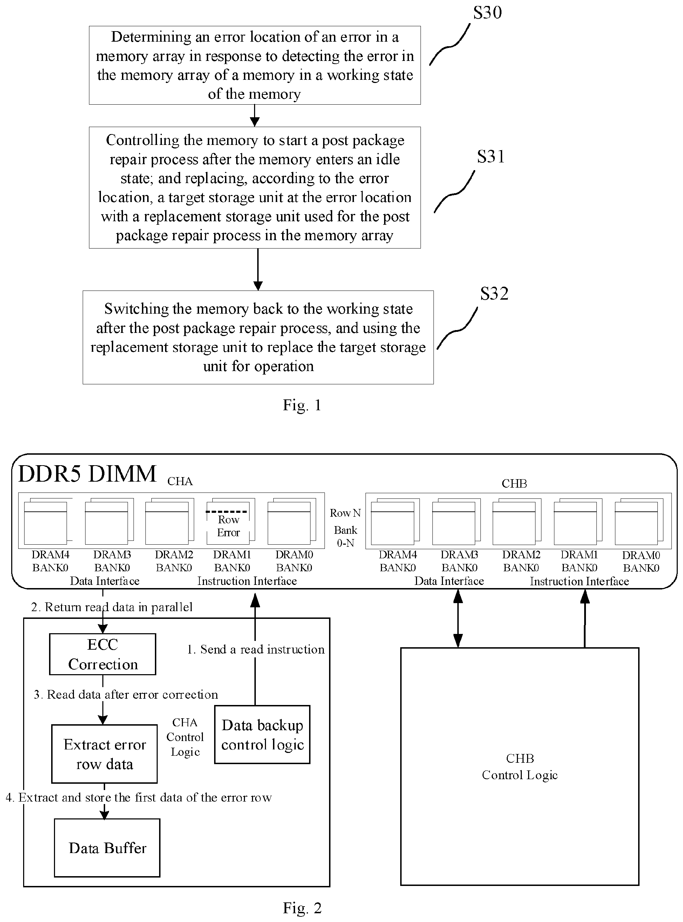

Fig. 1 illustrates a flow diagram of a memory operation method provided by at least one embodiment of the present disclosure.

As shown in Fig. 1, in some embodiments of the present disclosure, the memory operation method includes steps S30-S32.

Step S30, determining an error location of an error in a memory array in response to detecting the error in the memory array of a memory in a working state of the memory.

The memory may be dram. The working state of the memory, i. e., the memory has been powered up, e.g., initialization and configuration operations have been completed, whereby the memory is in a state of being accessed or manipulated. For example, the memory is in a state of being read, or the memory is in a state of being written. While the memory is in the working state, for example, the memory system may periodically or periodically detect an error in the memory array of the memory, and when an error is detected in the memory array while the memory is in the working state, the location of the error is determined in the memory array.

For example, the memory includes memory arrays(also referred to bank groups), a decode drive circuitry, a read/write circuitry, and the like, and is communicatively coupled to external devices, such as processors, direct memory access (DMA) controllers, and the like, via an address bus, a data bus, and a control bus, to receive access requests (e.g., reading and writing requests) from these hosts. The memory array includes a plurality of storage units (storage elements) arranged in an array having a plurality of rows and columns, e.g., the storage units are addressed by the rows and columns. For example, the decode drive circuitry includes an address decoder, a word line driver, a bit line driver, etc. Each storage unit may be, for example, a unit circuit such as a dynamic random access memory device (DRAM), a static random access memory device (SRAM), a flash memory (NAND or NOR), etc., depending on the type of memory.

For example, the presence of an error in the memory array indicates the presence of a bad unit in the memory array. For example, a particular error row in the memory array may be detected, or a particular number of error rows in the memory array may also be detected.

For example, an error row may be determined by detecting when a read request directed to a particular row fixedly returns erroneous data, or an error row may be determined by an error in a write request directed to a particular row.

For example, when an error in a memory array is detected, a memory system may record an error location of the error. For example, an error bank group, an error memory bank, an error row, and a storage unit number (also referred to as a memory particle number). For example, where multiple storage chips are involved, the error memory chip (Rank) can be recorded, each memory chip being a set of storage dies capable of in response to the same chip select (CS) signal. For example, when involving stacking of multiple dies in a three-dimensional chip, an erroneous component identifier (Component ID, CID) may be recorded for use by the CID to distinguish between different layers of core dies.

Step S31, controlling the memory to start a post package repair process after the memory enters an idle state, and replacing, according to the error location, a target storage unit at the error location with a replacement storage unit used for the post package repair process in the memory array.

An idle state (IDLE) of the memory refers to no access request (e.g., a read request or a write request) that can be currently performed by any storage units (e.g., DRAM dies) of a memory array in the memory. A target storage unit may also be referred to as a target memory particle, e.g., the target memory particle may be a DRAM die. It is in the state of waiting for the arrival of the next access request. For example, the idle state of the memory may be a low power consumption mode of the memory or a waiting mode. For example, the memory may be caused to enter an idle state by controlling a power management register (PCON), e.g., the IDL bit in the power management register is 1.

In some embodiments of the present disclosure, the memory operation method described above also includes a step S300.

Step S300, stop receiving a new access request to the memory and clearing existing access requests in the memory, to enable the memory to enter the idle state.

For example, when an error in the memory array of the memory is detected, there are a number of pending existing access requests in the memory in the working state and a new access request is capable to be accepted. The memory may thus be put into an idle state by stopping receiving new access requests to the memory and clearing existing access requests in the memory, leaving the memory without currently available access requests to be executed.

For example, the memory system may send a precharge command (Precharge, PRE) to the memory array to enable the memory to enter an idle state when the memory does not currently have an access request that can be executed. The PRE is used to close a row that is designated to be open in the memory array or to cancel all rows that are open in the memory array.

In some embodiments of the present disclosure, the memory operation method described above further includes a step S301 before the memory enters the idle state.

Step S301, releasing space of a data buffer occupied by the existing access requests.

The data buffer may be referred to simply as a cache, e.g., a cache dedicated to a memory, or a cache that may be multiplexed for other purposes, e.g., a first level cache, a second level cache, or a higher-level cache (e.g., a last level cache (LLC)). For example, the cache is performed before accessing the memory array of the memory, and thus the higher storage speed cache is used to solve the problem of higher delay when accessing the memory array, so as to improve the access performance to the memory array in the memory.

For example, when the memory receives a plurality of pending existing access requests, the buffering can be performed before accessing the memory array. The data buffer may have buffered the data of the existing access requests before accessing the memory array in the above-described operation, although the memory is emptied of the existing access requests. Since the existing access request has been emptied and the corresponding data in the data buffer will not be accessed anymore, the space of the data buffer occupied by the existing access request can be released before the memory enters the idle state.

The post package repair (PPR) process is a mechanism of memory repairing bad units in the memory array. In this process, the repair can be performed by preset replacement storage units, and the process of PPR process can also be controlled and indicated by reading the repair state register.

In some embodiments of the present disclosure, the memory operation method described above further includes the step S310 before initiating the post package repair process.

Step S310, reading a repair state register corresponding to the error location to determine whether repair resources are available.

For example, a corresponding repair state register may be provided for each storage unit in the memory array. For example, the repair state register may be a mode register MR54, MR55, MR56, or MR57 in the memory. The repair state register may be used to check whether a memory bank or bank group corresponding to the error location has a replacement storage unit available, e.g., the replacement storage unit is a repair resource available. For example, a row of memory locations are replacement rows (Redundant Rows) available, or a row of memory locations are replacement columns (Redundant Columns) available.

For example, the repair state register may determine if there are repair resources available by checking the PPR table.

For example, to initiate a post package repair (PPR) process, a series of operational controls may be required. For example, the memory may be a dynamic random access memory (DRAM). For example, according to the standard protocol of DDR4/DDR5, a series of PPR instruction sequences may be sent to initiate the PPR process of storing particles.

First, the memory may enter the PPR process by setting a partial bit of the repair control register to control the start of the PPR process. For example, the starting of the PPR process for the different modes can be controlled by repairing the control bits of the control register MR4. For example, the A13 bit of the repair control register MR4 is 1 to start a hard Post Package Repair (hPPR) mode. For example, the A5 bit of the repair control register MR4 is 1 to enable the soft Post Package Repair (sPPR) mode.

Next, a specific security code sequence (Guard Key) can be sent to ensure the validity and correctness of the operations in the PPR process by the security measures of the security code sequence.

Thereafter, in order to replace the target storage unit in the error location with a replacement storage unit in the memory array for the post package repair process according to the error location, the error location (for example, the target row address of the target storage unit) is required to be sent through an active command for making the target storage unit in the memory which is required to be replaced ready, and subsequent operations can be performed on the designated target storage unit (for example, the error row).

Next, after activating the command, a write command is sent to the memory to write the write data to the previously activated target storage unit, to select the target storage unit required to perform the PPR process by writing the write data. Since the write command generally includes data to be written and a target column address of the target storage unit, a specific and accurate location of the target storage unit of the memory required to perform an PPR process can be learned (namely, learning a target row address and a target column address of the target storage unit).

In some embodiments of the present disclosure, after the memory enters the idle state in step S31, the memory is controlled to start the post package repair process, and the operation method of the above-mentioned memory includes a step S311.

Step S311, switching the memory array from a working mode to a repair mode after the memory enters the idle state, to enable the memory to start the post package repair process.

When the memory array is in a working mode, the memory is in a working state, and at this time, the memory array reads and writes in the working state. When the memory array is in a repair mode, the storage starts a post package repair process, and at this time, the memory array repairs an error location therein via the post package repair process.

For example, the memory includes a storage controller which can control a memory array to read and write in a working state, and a repair module is included in the memory. The repair module can perform a repair operation on an error location of the memory array via the post package repair process. For example, in response to detecting an error in a memory array of a memory in a working state of the memory, control of the memory array may be switched from a storage controller to a repair module to switch the memory array from a working mode to a repair mode to enable the memory to initiate a post package repair process.

After the memory enters the post package repair process, according to the error location of the memory array, the replacement of the target storage unit (also referred to as a target memory particle) in the error location is performed with a replacement storage unit in the memory array for the post package repair process.

In at least one example, the replacement storage unit is a storage unit that can normally respond to an access request, and the replacement storage unit may be a storage unit in the memory array that is pre-partitioned for the post package repair process.

Step S32, switching the memory back to the working state after the post package repair process, and using the replacement storage unit to replace the target storage unit for operation.

Switching the memory back to the working state ends the post package repair process, e.g., the end of the PPR process can be controlled by setting partial bits of the repair control register. For example, the end of the PPR process may be controlled by repairing the control bits of control register MR4, e.g., repairing the A13 bit of control register MR4 to 0 to end the hPPR mode, or repairing the A5 bit of control register MR4 to 0 to end the sPPR mode.

For example, the memory array may be switched from a repair mode to a working mode, so that the memory ends the post package repair process. For example, the control of the memory array can be switched from the repair module to the storage controller, so that the memory ends the post package repair process.

Because the target storage unit in the error location has been replaced in the post package repair process with a replacement storage unit that can normally respond to the access request. Therefore, when the memory switches back to the working state, when the memory receives an access to the target storage unit in the error location of the memory array, the replacement storage unit is directly accessed, and the replacement storage unit is made to replace the target storage unit to perform an operation of responding to the access request.

With the above-mentioned steps S30-S32, when the memory is in the working state, in response to detecting an error in a memory array of the memory in the working state of the memory, the post package repair process can be dynamically triggered in time to repair an error in the memory which is in the working state, thereby improving the reliability of the memory.

In some embodiments of the present disclosure, after the memory enters the idle state, the memory operation method further includes a step S313.

Step S313, clearing a refresh command to be sent in the memory, to enable the memory array to enter a first self-refresh state; and switching control of the memory array from the working mode to the repair mode in the first self-refresh state.

For example, in at least one example, the post package repair process may not be initiated immediately after the memory enters the idle state, and a situation may arise in which the memory is required to wait in the idle state. For example, the memory is a dynamic random access memory (DRAM), and the DRAM is required to be refreshed according to a preset period so as to maintain the integrity of data. For example, after the memory enters the idle state, a storage controller in the memory also is required to issue a refresh command (Refresh, REF) according to a preset period.

Because it is not known how long to wait in the idle state, in order to make the process of starting the post package repair process of the memory from the working state of the memory smoothen, and not to cause data loss, the refresh command to be sent in the memory can be emptied, so that the memory array enters a self-refresh state (also referred to as a first self-refresh state herein). For example, after clearing the refresh commands to be sent in the storage controller, the storage controller may send a self-refresh entry (SRE) to the memory array, causing the memory to enter the first self-refresh state.

The self-refresh state is a low power consumption mode of the memory. In this mode, the memory array of the memory can use an internal counter to trigger the refreshing, and no external refresh command is needed, so that the internal data of the memory can be guaranteed to be not lost in the low power consumption mode.

For example, the memory array can be switched from the working mode to the repair mode in the first self-refresh state. For example, the control of the memory array is switched from a storage controller to a repair module in the first self-refresh state, so that the memory starts a post package repair process.

In some embodiments of the present disclosure, the memory operation method also includes a step S314.

Step S314, switching control of the memory array from the repair mode to the working mode in a second self-refresh state in response to completion of the repair mode.

For example, after completion of the repair mode, the same memory may not be restored to the working mode immediately, and a situation may arise in which a memory wait is required. The memory may be put into a second self-refresh state, since it is not known how long a wait is required, in order that the data in the memory is not lost and the power consumption of the memory is not too great. For example, the storage controller may send a self-refresh entry (SRE) to the memory array, causing the memory to enter the second self-refresh state.

When the memory can be switched, the memory array can be switched from the repair mode to the working mode in the second self-refresh state. For example, the control of the memory array is switched from the repair module to the storage controller in the second self-refresh state, so that the memory re-enters the working state.

In some embodiments of the present disclosure, the above-described post package repair process may include step S40 and step S41.

Step S40, backing up first data corresponding to the error location in response to the first self-refresh state being end.

After entering the post package repair process, in order to avoid replacing the target storage unit in the error location with the replacement storage unit, the data originally written in the target storage unit cannot be retained (for example, the data in the target storage unit is corrupted). Therefore, before the replacement of the target storage unit is performed, it is necessary to back up the data (also referred to as the first data) corresponding to the target storage unit at the error location.

Because the memory array of the memory has been set to the first self-refresh state before entering the post package repair process, and the data cannot be backed up in the self-refresh state, the storage controller can send a self-refresh refresh exit command (Self-exit, SRX) to enable the memory array to exit from the first self-refresh state so as to back up the first data corresponding to the error location.

Fig. 2 illustrates a schematic diagram of data backup provided by at least one embodiment of the present disclosure.

As shown in Fig. 2, in this embodiment, the memory uses a dual inline memory module (DIMM) structure of the DDR5 memory technology. In the DDR5 memory shown in the figure, each DIMM has two channels, a channel CHA and a channel CHB as shown in the figure. For example, the channel CHA and the channel CHB respectively have control logic corresponding to their channels. For example, each channel of the channel CHA and the channel CHB has the same number of memory arrays, and the channel CHA and the channel CHB can work in parallel, thereby significantly increasing the bandwidth of the memory and also increasing the data transmission rate.

For example, the channel CHA and the channel CHB each include five memory arrays, DRAM 0, DRAM 1, DRAM 2, DRAM 3, and DRAM 4, respectively. Each memory array includes a plurality of memory banks. For example, each of the five memory arrays DRAM 0-DRAM 4 includes a plurality of memory banks Bank 0-Bank N, and N is a positive integer.

For example, taking five memory arrays DRAM 0-DRAM 4 each including a memory bank Bank 0 as an example. For example, if an error is detected in the memory bank Bank 0 of the memory array DRAM 1, namely, an error exists in the memory array DRAM 1, an error line in the memory bank Bank 0 of the memory array DRAM 1 can be determined, for example, an error row being Row N, where N is a positive integer.

For example, a read instruction to an error row Row N may be sent first via the data backup logic. After the read instruction accesses the error row Row N of the channel CHA via the instruction interface, a target storage unit (also referred to as a target memory particle) of the error row Row N will return data for backup.

For example, in the bank interleaving technique, access requests are allowed to be handled in a distributed manner among a plurality of memory banks belonging to a plurality of memory arrays, respectively. For example, when an access request is issued, the access data may be stored scattered among the memory banks of different memory arrays. For example, the access data in an access request may be stored in a memory bank Bank 0 of five memory arrays DRAM 0-DRAM 4, respectively. By the bank interleaving techniques, memory parallelism can be greatly improved, and the latency of data access can be reduced by reducing the delay caused by waiting for a single bank operation to complete.

For example, with regard to the memory adopting the bank interleaving technique, after receiving a read instruction for an error row Row N in a memory bank Bank 0 of a memory array DRAM 1, when an access request is performed to write access data, corresponding rows Row N of the memory bank Bank 0 in five memory arrays DRAM 0-DRAM 4 are simultaneously written into the access data in parallel. Therefore, when the error row Row N in the memory bank Bank 0 of the memory array DRAM 1 is read, the corresponding row Row N of the memory bank Bank 0 in other memory arrays would be read out together, namely, reading out data of the corresponding row Row N of the memory bank Bank 0 in five memory arrays DRAM 0-DRAM 4 respectively in parallel as returned read data.

In some embodiments of the present disclosure, the step S40 includes a step S400.

Step S400, performing the backing up after processing the first data by an error correction algorithm.

For example, after reading the read data, the error checking and correction (ECC) may be performed on the read data to obtain error-corrected read data, so that the read data to be backed up may be made correct.

In some embodiments of the present disclosure, the step S400 further includes a step S4001.

Step S4001, backing up the first data corresponding to the error location to a redundant space of the space of the data buffer.

For example, the data (also referred to as first data) of the target memory particle of the error row Row N in the memory bank Bank 0 of the memory array DRAM 1 can be extracted from the error-corrected read data and stored in a data buffer.

For example, the first data may be stored in the space occupied by the released existing access request, so that there is no need to divide up a backup storage space for backing up the first data, and no need to introduce additional storage apparatus in the memory.

In some embodiments of the present disclosure, if the number of data bits in the read data is too large in the backup process, i.e., the number of columns of memory particles in the memory arrays DRAM 0-DRAM 4 in the channel CHA exceeds the number of columns that the storage controller can process at one time, this number of bits cannot be accessed at the same time in a single operation of the storage controller. Thus, it can be processed by partial column access that reads a portion of the number of columns at a time. For example, the number of bits to read data is 64 bits. In the embodiment described above, a read command may be sent to read the data in columns 0-15, then the next column 16-31, then columns 32-47, and finally columns 48-63. Thus, all columns (i.e., all bits) of the read data are overwritten by a plurality of circular reads, thereby completing the backup of the first data.

It should be noted that the above description is made by taking the memory as an DDR5 DIMM structure as an example, but this does not represent a limitation on the type of memory structure in the present disclosure. The above-mentioned description is made by taking the memory including two channels as an example, but does not represent a limitation on the number of channels of the memory. The above is illustrated by an example in which one channel includes five memory arrays, but this is not meant to limit the number of memory arrays in the memory.

The above-mentioned embodiments of the present disclosure are described as an example of an error action of a memory bank in a memory array. If there are multiple memory banks in the memory array including multiple error locations or an error location including multiple error rows, the backup process for any one of the error rows is the same as the above-mentioned examples.

It should be noted that in the above example, the data backup procedure in the case of an error in any of the memory arrays in the channel CHB is the same as the data backup procedure in the channel CHA, and the description of this disclosure will be omitted here.

Step S41: restoring the first data to the replacement storage unit after the target storage unit is replaced with the replacement storage unit.

For example, after a target storage unit is replaced with a replacement storage unit, the data (e.g., first data) of the previously replaced target storage unit (also referred to as the target storage grain) is required to be restored to the replacement storage unit.

In some embodiments of the present disclosure, the step S41 includes a step S410.

Step S410, recombining the first data corresponding to the error location and second data written in parallel with the first data, and performing a write operation on the recombined data to restore the first data to the replacement storage unit.

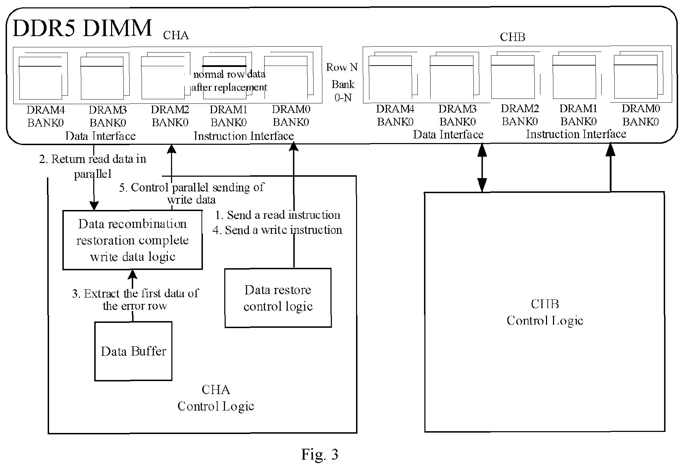

Fig. 3 illustrates a schematic diagram of data restoration provided by at least one embodiment of the present disclosure.

As shown in Fig. 3, in this embodiment, the memory uses a dual inline memory module structure of the DDR5 memory technology. In the DDR5 memory shown in the figure, each DIMM has two channels, a channel CHA and a channel CHB as shown in the figure. For example, the channel CHA and the channel CHB respectively have control logic corresponding to their channels. For example, each channel of the channel CHA and the channel CHB has the same number of memory arrays, and the channel CHA and the channel CHB can work in parallel, thereby significantly increasing the bandwidth of the memory and also increasing the data transmission rate.

For example, the channel CHA and the channel CHB each include five memory arrays, DRAM 0, DRAM 1, DRAM 2, DRAM 3, and DRAM 4, respectively. Each memory array includes a plurality of memory banks (Bank). For example, each of the five memory arrays DRAM 0-DRAM 4 includes a plurality of memory banks Bank 0-Bank N, and N is a positive integer.

Taking the channel CHA using the bank interleaving technique as an example, for example, the control logic corresponding to the channel CHA includes a data recombination restoration complete write data logic, a data restoration control logic and a data buffer.

First, after a target storage unit (also referred to as a target memory particle) is replaced with a replacement storage unit, a read command is sent to the replaced channel CHA.

Subsequently, the channel CHA, in response to a read command, reads out the data of the replacement storage unit in the memory array DRAM 1 as well as the data (also referred to as second data) in other memory arrays read out in parallel with the memory array DRAM 1. For example, the read data which are read out in parallel respectively include data for a row Row N in a memory bank Bank 0 of a memory array DRAM 0, data for replacement storage units in a memory bank Bank 0 of a memory array DRAM 1, data for a row Row N in a memory bank Bank 0 of a memory array DRAM 2, data for a row Row N in a memory bank Bank 0 of a memory array DRAM 3, and data for a row Row N in a memory bank Bank 0 of a memory array DRAM 4.

Then, the data of the error row Row N (i.e., the target storage unit) in the memory bank Bank 0 of DRAM 1 (hereinafter, also referred to as "first data") is extracted from the data buffer.

Thereafter, the first data is required to be recombined with the second data in order to restore the complete write data. Note that the second data is data written in parallel with the first data.

For example, the data of the replacement storage unit in the read data may be replaced by the first data by data recombination, to reorganize the first data with the second data to restore the complete write data. For example, during the data recombination, data from a replacement storage unit in a bank Bank 0 of a memory array DRAM 1 in the read data may be replaced with the first data to restore the complete write data.

For example, the restored complete write data is data of a row Row N in a bank Bank 0 of the memory array DRAM 0, first data, data of a row Row N in a bank Bank 0 of the memory array DRAM 2, data of a row Row N in a bank Bank 0 of the memory array DRAM 3, and data of a row Row N in a bank Bank 0 of the memory array DRAM 4. Here, the second data includes other data in the write data than the first data.

After sending a write instruction to the channel CHA, the data restoration control logic controls the recombined data to be written into the memory arrays DRAM 0-DRAM 4 of the channel CHA, for example, writing the first data into a replacement storage unit in the memory bank Bank 0 of the memory array DRAM 1, and correspondingly writing the second data into the memory array DRAM 0, the memory array DRAM 2, the memory array DRAM 3 and the memory array DRAM 4, respectively.

By recombing the read data in the plurality of memory arrays with the first data as described above, it is possible for a memory employing the bank interleaving technique to not cause normal data of other memory arrays to be overwritten or corrupted due to restoring errors in one of the plurality of memory arrays.

In some embodiments of the present disclosure, the step S41 includes a step S411.

Step S411, restoring the first data to the replacement storage unit by operating a corresponding data mask to mask out the operation of the second data to be written in parallel with the first data corresponding to the error location.

For example, the memory supports a data mask function. Thus, when the data (also referred to as first data) in the target storage unit is restored to the replacement storage unit, the data mask can be used to mask out the operation of the second data to be written in parallel with the first data corresponding to the error location, so that the first data can be restored directly to the replacement storage unit without data recombination,. The data masking method does not need to perform the above-mentioned read-modify-write (RMW) process, i. e., it does not need to first send a read request to read the read data written in parallel (i. e., reading), then perform data recombination, (i. e., correcting), and then write the write data after the data recombination, (i. e., writing), which can further optimize the restoration process of post package repair, so as to shorten the time consumption of post package repair.

For example, as shown in Fig. 3, five memory arrays DRAM 0-DRAM 4 in a channel CHA respectively correspond to data mask bits. For example, a target storage unit at an error location in a bank Bank 0 of a memory array DRAM 1 has been replaced with a replacement storage unit. Although the memory adopts the bank interleaving technique, and the five memory arrays need to be read and written in parallel. The memory array DRAM 0, the memory array DRAM 2, the memory array DRAM 3 and the memory array DRAM 4 can be masked by setting the data mask bits, so that the memory array DRAM 1 can be operated. In this way, after reading the first data in the data buffer, the operation of masking the second data to be written in parallel with the first data corresponding to the error location can be performed, and the first data can be directly restored to the replacement storage unit.

It should be noted that in the case where the first data, read data and write data in the restoration process of the memory array are too large, namely, when the number of columns of the storage dies in the memory arrays DRAM 0-DRAM 4 or DRAM 1 in the channel CHA exceeds the number of columns that can be processed once by the storage controller, the first data, read data or write data can also be processed in a partial column access manner, and the restoration of the first data can be completed by a plurality of cycles of processing until all the columns (namely, all the number of bits) of the first data, read data and write data are covered.

It should be noted that in the above example, the data restoration process of any memory array in the channel CHB is the same as the data restoration process in the channel CHA, and the description of this disclosure will not be repeated here.

In some embodiments of the present disclosure, the memory operation method further includes a step S33.

Step S33, sending a compensated refresh command in response to completion of the post package repair process.

By sending a compensated refresh command, the memory is enabled to compensate for refresh operations that cannot be performed during the PPR process after the PPR process is completed.

For example, the compensated refresh command may be sent after restoring the first data to the replacement storage unit.

By sending a compensated refresh command, the integrity of the data in the memory is not affected by charge leakage during PPR as a result of no refresh, and the stability of the data in the memory is maintained.

In some embodiments of the present disclosure, the memory operation method further includes a step S34.

Step S34, triggering a hard repair on the memory array in response to a reset operation or an initialization operation on the memory, so as to fix, in the memory array of the memory, a repair result of replacing the target storage unit at the error location with the replacement storage unit for the post package repair process in the memory array.

For example, the above-mentioned post package repair process can be a soft Post Package Repair (sPPR) which takes a relatively short time. In order to fix the repair result of the above-mentioned post package repair process, the repair result can be recorded in advance. When a reset operation or an initialization operation is performed on a memory, according to the recorded repair result (namely, a replacement relationship of replacing a target storage unit at an error location with a replacement storage unit), a hard repair on a memory array is triggered. For example, the hard repair may be a hard Post Package Repair (hPPR) to fix the repair results in the memory array of the memory by physically changing the memory particles in the memory array.

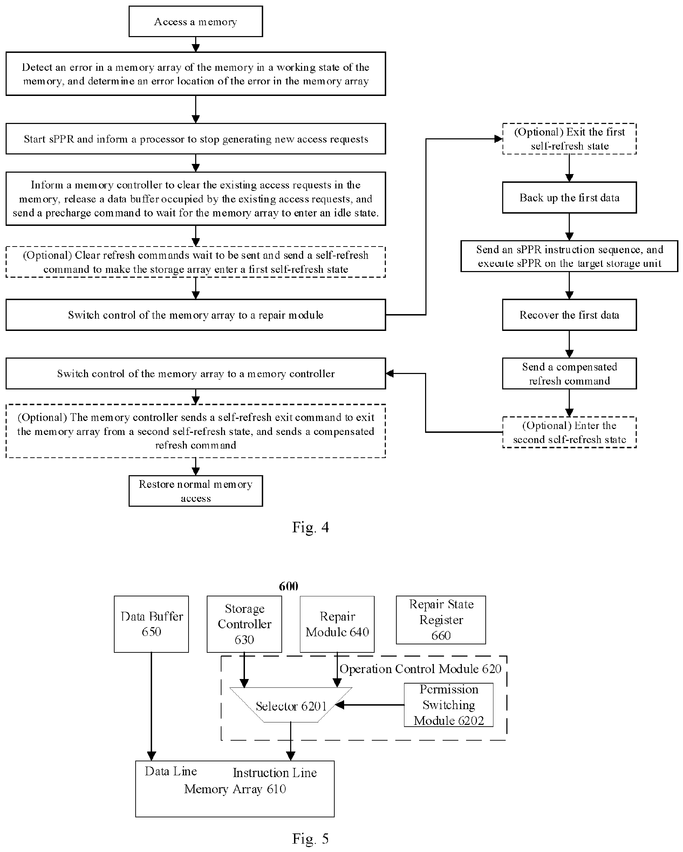

Fig. 4 illustrates an exemplary flow diagram of a memory operation method provided by at least one embodiment of the present disclosure.

As shown in Fig. 4, the flow of a memory operation method may be as follows. When an access request to the memory is sent to access the memory, an error location of the error in the memory array is determined in response to detecting an error in a memory array of the memory in a working state of the memory.

Thereafter, the soft Post Package Repair (sPPR) process is initiated to notify the processor to stop generating new access requests.

Later, the storage controller is notified to clear the existing access request in the memory, release the data buffer occupied by the existing access request, and send a pre-charge command to wait for the memory array to enter an idle state.

After entering an idle state, if waiting is needed at this time, a refresh command to be sent can be cleared, a self-refresh entry is sent to make the memory array enter a first self-refresh state, and a control of the memory array is switched to a repair module in the first self-refresh state. If there is no need to wait at this time, the control of the memory array can be switched to the repair module directly in the idle state, so as to enter the soft post package repair process.

If the control of the memory array is switched to the repair module in the first self-refresh state, the first self-refresh state is required to be exited before the first data is backed up. If the control of the memory array is switched to the repair module directly in the idle state, the backup of the first data can be directly started.

Later, an instruction sequence for starting the sPPR process is sent, the sPPR process on the target storage unit at the error location is executed in the memory array, and the target storage unit is replaced with the replacement storage unit.

Thereafter, the first data is restored to the replacement storage unit, and a compensated refresh command is sent after the restoration process is completed.

If the waiting is needed at this time, a self-refresh entry can be sent to make the memory array enter a second self-refresh state, and the control of the memory array is switched to the storage controller in the second self-refresh state. If the waiting is not needed, the control of the memory array can be directly switched to the storage controller.

If the control of the memory array is switched to the storage controller in the second self-refresh state, the storage controller may send a self-refresh exit command, enable the memory array exit the second self-refresh state, and send a compensated refresh command.

Normal access to the memory is restored by causing the memory to restore errors in the memory array of the memory to be repaired as described above.

The technical effects of the above-mentioned embodiments of the present disclosure are the same as the technical effects of the above-mentioned memory operation method, and therefore the description thereof will not be repeated.

Fig. 5 illustrates a block schematic diagram of a memory provided by at least one embodiment of the present disclosure.

As shown in Fig. 5, at least one embodiment of the present disclosure also provides a memory 600 including a memory array 610, an operation control module 620, a storage controller 630, and a repair module 640.

The storage controller 630 is configured to perform reading and writing operations on the memory array 610 in a working state.

The repair module 640 is configured to perform repair operations on the memory array 610.

The operation control module 620 is configured to determine the location of the error in the memory array 610 in response to detecting the error in the memory array 610 of the memory 600 in the working state of the memory 600, and control the memory 600 to initiate a repair module 640 for performing a post package repair process after the memory 600 enters the idle state.

The repair module 640 is further configured to execute, according to the error location, the replacement of the target storage unit at the error location with a replacement storage unit in the memory array 610 used for the post package repair process, and switch the memory 600 back to the working state after the post package repair process, whereby the storage controller 630 operates by replacing the target storage unit with the replacement storage unit.

For example, the memory 600 may be a memory. Correspondingly, the storage controller 630 may be a memory controller.

For example, the storage controller 630 is further configured to manage refresh operations of the memory array 610.

For example, the repair module 640 is configured to control the sending of a series of PPR instruction sequences to the memory array 610 during the post package repair process to initiate the PPR process.

In some embodiments of the present disclosure, the operation control device includes a selector 6201 and a permission switching module 6202.

The selector 6201 is, for example, a multiplexer, an input terminal of the selector 6201 is connected to the storage controller 630 and the repair control module, and an output terminal of the selector 6201 is connected to the memory array 610.

The permission switching module 6202 is configured to provide a control signal to the selector 6201 to enable the selector 6201 to switch from the working mode to the repair mode or from the repair mode back to the working mode for the memory array 610.

In some embodiments of the present disclosure, the memory 600 further includes a data buffer 650. The data buffer 650 is configured to provide the buffer space required for the memory array 610 in the working mode or the repair mode. For example, the data buffer 650 is configured as a buffer space for temporarily storing reading and writing data in the working state of the memory. For example, the data buffer 650 is configured to provide a buffer space for backing up the first data corresponding to the error location in the repair mode of the memory.

For example, in a working mode of the memory, a permission switching module 6202 gives the control of a memory array 610 to a storage controller 630 via a selector 6201. At this moment, the storage controller 630 can normally respond to a read-write request issued by a processor, and a data buffer 650 can temporarily store read-write data. When the memory is required to perform a repair operation on the memory array 610, a control switching process is started. When the memory 600 clears an existing access request and allows the memory array 610 to enter a first self-refresh state, the control switching module 6202 gives the control of the memory array 610 to the repair module 640 via the selector 6201, and then starts to execute a post package repair process. At this time, the data buffer 650 is configured to temporarily store error row data (first data). After the completion of the post package repair process, the permission switching module 6202 then transfers the control of the memory array 610 to the storage controller 630 via the selector 6201, and enables the memory array 610 to return to a normal state.

In some embodiments of the present disclosure, the memory 600 further includes a repair state register 660. The repair state register 660 is configured to record whether repair resources are available at the location of the error.

In some embodiments of the present disclosure, operation control module 620 may include a repair control register (not shown in the figure).

In some embodiments of the present disclosure, the storage controller 630 is further configured to stop receiving a new access request to the memory 600 and clear existing access requests in the memory 600, to enable the memory 600 to enter the idle state.

In some embodiments of the present disclosure, the storage controller 630 is further configured to release space of a data buffer 650 occupied by the existing access requests.

In some embodiments of the present disclosure, the storage controller 630 is further configured to clear a refresh command to be sent in the memory 600, to enable the memory array 610 to enter a first self-refresh state. The operation control module 620 is further configured to switch control of the memory array 610 from the working mode to the repair mode in the first self-refresh state.

In some embodiments of the present disclosure, the repair module 640 is further configured to back up the first data corresponding to the error location in response to the first self-refresh state being end, and restoring the first data to the replacement storage unit after the target storage unit is replaced with the replacement storage unit.

In some embodiments of the present disclosure, the repair module 640 is further configured to perform the backing up after processing the first data by an error correction algorithm.

In some embodiments of the present disclosure, the repair module 640 is further configured to back up the first data corresponding to the error location to a redundant space of the space of the data buffer 650.

In some embodiments of the present disclosure, the repair module 640 is further configured to recombine the first data corresponding to the error location and second data written in parallel with the first data, and perform a write operation on the recombined data to restore the first data to the replacement storage unit.

In some embodiments of the present disclosure, the memory array 610 is configured to support data masking, and the repair module 640 is further configured to restore the first data to the replacement storage unit by operating a corresponding data mask to mask out the operation of the second data to be written in parallel with the first data corresponding to the error location.

In some embodiments of the present disclosure, the storage controller 630 is further configured to send a compensated refresh command in response to the completion of the post package repair process.

In some embodiments of the present disclosure, the operation control module 620 is further configured to switch the control of the memory array from the repair mode to the working mode in a second self-refresh state in response to completion of the repair mode.

In some embodiments of the present disclosure, the storage controller 630 is further configured to read a repair state register 660 corresponding to the error location to determine whether repair resources are available.

In some embodiments of the present disclosure, the repair module 640 is further configured to trigger a hard repair on the memory array 610 in response to a reset operation or an initialization operation on the memory, to fix, in the memory array 610 of the memory 600, a repair result of replacing the target storage unit at the error location with the replacement storage unit for the post package repair process in the memory array.

The operation control module 620, the repair module 640, the permission switching module 6202, and the like in the above-mentioned embodiment of the present disclosure may be implemented, for example, by hardware, software, firmware, or any combination thereof, for example, by digital circuitry. The technical effects of the memory of the above-mentioned embodiments of the present disclosure are the same as the technical effects of the above-mentioned memory operation method, and therefore the description thereof will not be repeated.

At least one embodiment of the present disclosure also provides an electronic device, where the electronic device includes a memory as recited in at least one embodiment above.

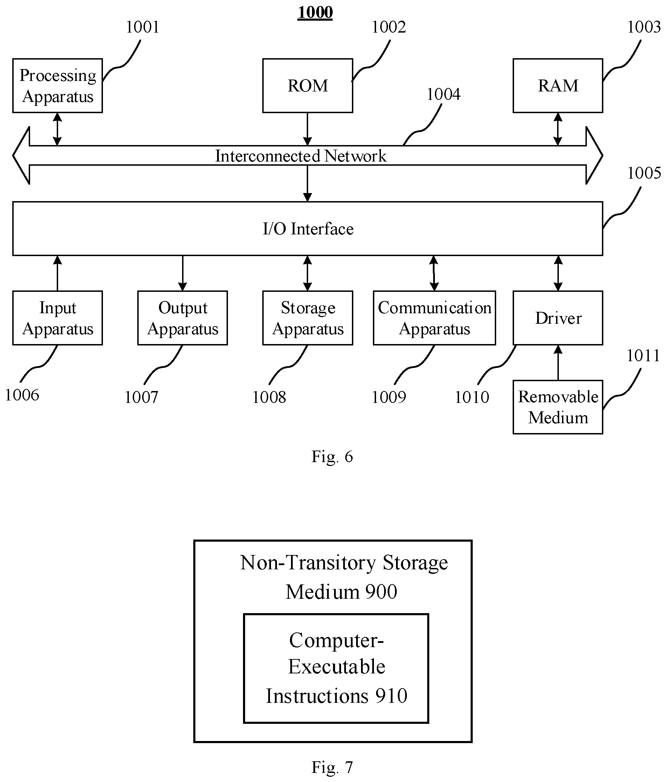

Fig. 6 is a schematic block diagram of an electronic device according to at least one embodiment of the present disclosure.

The electronic apparatus in the embodiment of the present disclosure may include, but is not limited to, a mobile terminal such as a mobile phone, a notebook computer, a digital broadcast receiver, a PDA (personal digital assistant), a PAD (tablet computer), a PMP (portable multimedia player), an in-vehicle terminal (e.g., in-vehicle navigation terminal), etc., and a fixed terminal such as a digital TV, a desktop computer, etc. The electronic device 1000 shown in Fig. 6 is merely an example and should not pose any limitation on the scope of use or functionality of embodiments of the present disclosure.

For example, with reference to Fig. 6, in some examples, the electronic device 1000 includes a processing apparatus (e.g., a central memory, a graphics memory, etc.) 1001 that may perform various suitable actions and processes in accordance with a program stored in a read only memory (ROM) 1002 or a program loaded from the storage apparatus 1008 into a random access memory (RAM) 1003. In the RAM 1003, various programs and data required for the operation of a computer system are also stored. For example, the RAM 1003 may be a memory device as described in at least one embodiment of the present disclosure above, with the processing device 1001, the ROM 1002, and the RAM 1003 being coupled via the interconnected network 1004. An input/output (I/O) interface 1005 is also connected to the Internet 1004.

For example, the following components may be connected to the I/O interface 1005: an input apparatus1006 including, for example, a touch screen, a touch pad, a keyboard, a mouse, a camera, a microphone, an accelerometer, a gyroscope, etc.; an output apparatus1007 such as a liquid crystal display (LCD), a speaker, a vibrator, etc.; a storage apparatus 1008 including, for example, a magnetic tape, a hard disk, etc.; and communication apparatuses 1009, including, for example, a network interface card such as a LAN card, a modem, etc. The communication apparatus 1009 may allow the electronic device 1000 to communicate wirelessly or wiredly with other devices to exchange data, and perform communication processing via a network such as the Internet. The driver 1010 is also connected to the I/O interface 1005 as required. A removable medium 1011, such as a magnetic disk, an optical disk, a magneto-optical disk, a semiconductor memory, or the like, is mounted on the drive 1010 as needed so that a computer program read therefrom can be loaded into the storage apparatus 1008 as needed. Although Fig. 6 illustrates an electronic device 1000 including various apparatuses, it should be understood that not all of the illustrated apparatuses are required to be implemented or included. More or fewer apparatuses may alternatively be implemented or included.

For example, the electronic device 1000 may further include a peripheral interface (not shown in the figure) or the like. The peripheral interface may be of various types, such as a USB interface, a lighting interface, etc. The communication apparatus 1009 may communicate by wireless communication with networks such as the Internet, intranets and/or wireless networks such as cellular telephone networks, Wireless Local Area Networks (LAN) and/or Metropolitan Area Networks (MAN), and other devices. The wireless communication may use any of a variety of communication standards, protocols, and technologies including, but not limited to, Global System for Mobile Communications (GSM), Enhanced Data GSM Environment (EDGE), Wideband Code Division Multiple Access (W-CDMA), Code Division Multiple Access (CDMA), Time Division Multiple Access (TDMA), Bluetooth, Wi-Fi (e.g., based on the IEEE 802.11a, IEEE 802.11b, IEEE 802.11g, and/or IEEE 802.11n standards), Voice over Internet Protocol (VoIP), Wi-MAX, protocols for e-mail, instant messaging, and/or short message service (SMS), or any other suitable communication protocol.

For example, the electronic device 1000 may be any device such as a cellular phone, a tablet computer, a notebook computer, an electronic book, a game machine, a television, a digital photo frame, a navigator, a server, etc., or may be any combination of an operating apparatus of a memory and hardware. The embodiments of the present disclosure are not limited thereto.

At least one embodiment of the present disclosure also provides a non-transitory storage medium for non-transitorily storing computer-executable instructions. For example, a memory operation method provided by at least one embodiment of the present disclosure is implemented when computer-executable instructions are executed by the memory.

Fig. 7 is a schematic diagram of a non-transitory storage medium provided by at least one embodiment of the present disclosure. As shown in Fig. 7, a non-transitory storage medium 900 may store computer-executable instructions 910 which, when executed by a computer, implement the memory operation method provided by any of the embodiments of the present disclosure.

With regard to the present disclosure, there are the following points to be described.
(1) In the drawings of embodiments of the disclosure, it refers to only the structures related to the embodiments of the disclosure, and other structures may be referred to by general designs.
(2) Features from the same embodiment or different embodiments of the disclosure may be combined with each other without departing from the scope of the disclosure.

The description above is only specific embodiments of the present disclosure, but the scope of protection of the present disclosure is not limited thereto. Any changes and substitutions which can be easily made by those skilled in the art within the technical scope of the present disclosure disclosed are included in the scope of protection the present disclosure. Accordingly, the scope of protection of the present disclosure should be determined with reference to the claims.

## Claims

1. A memory operation method, comprising:
determining an error location of an error in a memory array in response to detecting the error in the memory array of a memory in a working state of the memory;
controlling the memory to start a post package repair process after the memory enters an idle state, and replacing, according to the error location, a target storage unit at the error location with a replacement storage unit used for the post package repair process in the memory array; and
switching the memory back to the working state after the post package repair process, and using the replacement storage unit to replace the target storage unit for operation.

2. The memory operation method according to claim 1, wherein the controlling the memory to start a post package repair process after the memory enters an idle state comprises:
switching the memory array from a working mode to a repair mode after the memory enters the idle state, to enable the memory to start the post package repair process.

3. The memory operation method according to claim 2, further comprising:
stop receiving a new access request to the memory and clearing existing access requests in the memory, to enable the memory to enter the idle state.

4. The memory operation method according to claim 3, wherein before the memory enters the idle state, the memory operation method further comprises:
releasing space of a data buffer occupied by the existing access requests.

5. The memory operation method according to claim 4, wherein after the memory enters the idle state, the memory operation method further comprises:
clearing a refresh command to be sent in the memory, to enable the memory array to enter a first self-refresh state; and
switching control of the memory array from the working mode to the repair mode in the first self-refresh state.

6. The memory operation method according to claim 5, wherein the post package repair process comprises:
backing up first data corresponding to the error location in response to the first self-refresh state being end, and restoring the first data to the replacement storage unit after the target storage unit is replaced with the replacement storage unit.

7. The memory operation method according to claim 6, wherein the backing up first data corresponding to the error location comprises:
performing the backing up after processing the first data by an error correction algorithm.

8. The memory operation method according to claim 6 or 7, wherein the backing up first data corresponding to the error location further comprises:
backing up the first data corresponding to the error location to a redundant space of the space of the data buffer.

9. The memory operation method according to any one of claims 6-8, wherein the restoring the first data to the replacement storage unit comprises:
recombining the first data corresponding to the error location and second data written in parallel with the first data, and performing a write operation on the recombined data to restore the first data to the replacement storage unit.

10. The memory operation method according to any one of claims 6-8, wherein the memory array is configured to support data masking; and
the restoring the first data to the replacement storage unit comprises:
restoring the first data to the replacement storage unit by operating a corresponding data mask to mask out the operation of the second data to be written in parallel with the first data corresponding to the error location.

11. The memory operation method according to any one of claims 5-10, further comprising:
sending a compensated refresh command in response to completion of the post package repair process.

12. The memory operation method according to any one of claims 5-11, further comprising:
switching the control of the memory array from the repair mode to the working mode in a second self-refresh state in response to completion of the repair mode.

13. The memory operation method according to any one of claims 1-12, wherein before initiating the post package repair process, the method further comprises:
reading a repair state register corresponding to the error location to determine whether repair resources are available.

14. The memory operation method according to any one of claims 1-13, further comprising:
triggering a hard repair on the memory array in response to a reset operation or an initialization operation on the memory, to fix, in the memory array of the memory, a repair result of replacing the target storage unit at the error location with the replacement storage unit for the post package repair process in the memory array.

15. A memory, comprising a memory array, an operation control module, a storage controller, and a repair module, wherein
the storage controller is configured to perform reading and writing operations on the memory array in a working state;
the repair module is configured to perform a repair operation on the memory array; and
the operation control module is configured to:
determine an error location of the error in the memory array in response to detecting an error in the memory array of the memory in the working state of the memory;
control, after the memory enters an idle state, the memory to activate the repair module to perform a post package repair process, wherein the repair module is further configured to replace, according to the error location, a target storage unit at the error location with a replacement storage unit used for the post package repair process in the memory array; and
switch the memory back to the working state after the post package repair process, thereby the storage controller using the replacement storage unit to replace the target storage unit for operation.

16. The memory according to claim 15, wherein the operation control module comprises:
a selector, wherein an input terminal of the selector is connected to the storage controller and the repair control module, and an output terminal of the selector is connected to the memory array; and
a permission switching module, configured to provide a control signal to the selector to enable the selector to switch control of the memory array from a working mode to a repair mode or from the repair mode back to the working mode.

17. The memory according to claim 15 or 16, further comprising:
a data buffer, configured to provide a buffer space required for the memory array in the working mode or the repair mode.

18. The memory according to any of claims 15-17, further comprising:
a repair state register, configured to record whether repair resources are available at the error location.

19. An electronic device, comprising the memory according to any one of claims 15 to 18.

20. A non-transitory storage medium for non-transitorily storing computer-executable instructions, wherein the computer-executable instructions, when executed by at least one processor, implement the memory operation method according to any one of claims 1-14.
